# EUROPEAN PATENT APPLICATION

(11) **EP 3 130 689 A1**
(43) Date of publication of application: **15.02.2017**
(21) Application number: 16001871.9
(22) Date of filing: 05.08.2013
(51) Int. Cl.: C23C 16/46, H05B 3/14, H05B 3/24

(54) **HEATING ELEMENT FOR A PLANAR HEATER OF A MOCVD REACTOR**

(30) Priority: 07.08.2012 US 201213568915
(62) Divisional of application: 13753087.9
(71) Applicant: Plansee SE, 6600 Reutte (AT); Veeco Instruments Inc., Plainview, NY 11803 (US)
(72) Inventor: Martinz, Hans-Peter, A-6600 Wängle (AT); Sulik, Manfred, A-6600 Reutte (AT); Boguslavskiy, Vadim, Princeton, NJ 08540 (US)
(74) Representative: Ciesla, Bettina

(57) **Abstract**

The invention is related to a heating element (10) comprising a heating body (20) which is directly covered at least partly with a porous sintered coating (30), wherein the heating body (20) the porous sintered coating (30) each comprises at least 90 % by weight of tungsten.

## Description

The present invention relates to a heating element for planar heater of a MOCVD reactor as well as a method for manufacturing a heating element for a planar heater of a MOCVD reactor, as well as other reactors and furnaces.

Heating elements mounted within chambers of MOCVD reactors are commonly known. For example they are used to create a process temperature for the production of LEDs (Light emitting diodes) in a metal organic chemical vapor deposition (MOCVD) reactor. The process temperature for these processes is usually defined to be between 450 and 1250° Celsius. One or more wafers, upon which are grown compound semiconductors, are mounted on a rotating plate, or susceptor, which is spaced away from the heater element. Since the susceptor is spaced away from the heater element, the heater element has to be heated to a temperature substantially above the process temperature of the wafers itself. The temperature for the heating element for most of the process is therefore usually between 1000 and 2200°Celsius.

To resist such high temperatures, a refractory metal, for example tungsten, molybdenum, niobium, tantalum, rhenium, and alloys thereof, is used for such heating elements. However, at such elevated temperatures, most of the energy used to heat up the rotating plate in a MOCVD reactor is transferred by radiation. The radiated performance of said heating element is proportional to the emissivity of the radiating element, namely the heating element. Usually, heating elements made of a material comprising tungsten have an emissivity value between 0.15 and 0.4 (with reference to a black body). Due to a very low emissivity value, the operating temperature of the heating element is very high. This results in short life time of the heaters and a need for frequent replacement.

Attempts have been tried to use several coatings on the heating element to increase the usable life time of the heating element. For example, United States Patent 3,808,043 discloses the idea that a refractory metal heater has two coatings, namely a first coating comprising an aluminum oxide and a second coating comprising tungsten material. One problem of such a heating element is the relatively complex way of manufacturing. In particular, it has to be assured that the two coatings coat each other in a safe manner. Furthermore, two coating steps are necessary during the manufacturing of such heating element. Moreover, the stability of such dual coating over time and over the high temperatures during the MOCVD process can result in the coatings falling off of the heater.

Based on the foregoing, it is an object of the present invention to overcome the aforementioned problems. Moreover, it is an object of the present invention to provide a heating element as well as a method for manufacturing a heating element for a planar heater of a MOCVD reactor and a heating body, which is easy and relatively inexpensive to manufacture and increases the emissivity of the heating element in a satisfactorily long-time stable manner.

Aforesaid problems are solved by the heating element for a planar heater of a MOCVD reactor as well as by a method for making such a heater and a heating body, as well as further details regarding such inventions which are set out in the present application. Further features and details of the present invention discussed with respect to the subclaims can be combined freely with each other as well as with the inventive heating element, the inventive method and the inventive heating body.

According to the present invention, the heating element, in particular for a planar heater of a MOCVD reactor, comprises a heating body. The heating body is directly covered at least partly with a porous sintered coating. Thereby, the heating body and the porous sintered coating each comprises at least 90% by weight of tungsten. According to the present invention, a planar heater is a heating element, which can be used to be part of a planar heater. "Planar" in the sense of the present application is meant as at least substantially planar. Any heater, which extends without dislocation out of one plane not more than 10%, is to be considered as a planar heater according to the present invention. Due to the needs of an MOCVD reactor, the inventive heating element is in particular used for such a MOCVD reactor.

The heating element of the present invention can be used for a planar heater of a MOCVD reactor, such heating element of the present invention can also be called a MOCVD heating element or a planar MOCVD heating element. Those skilled in the art will appreciate that the heating element disclosed herein can be used in other situations such as other reactors and furnaces.

One big advantage of an inventive heating element is the fact that the heating body is at least partly covered with a porous sintered coating. The term "porous sintered coating" can be understood as a coating, which has been manufactured by a sintering process. The sintering process has been carried out in such a way that pores, which have been created during coating still remain in the surface layer after that sintering process. Because of those pores, the porous sintered coating possesses higher surface area than the respective underlying planar surface of the heating body. In other words, the surface of the heating element is increased by the use of the porous sintered coating.

The use of such a porous sintered coating and the respective resulting higher surface area leads to an increased emissivity factor of the heating element itself. By the use of the present invention, the emissivity of the heating element can for example be increased up to a value greater than or equal to 0.5. In particular, a value for the emissivity can be reached with the inventive heating element between 0.65 and 0.75. Moreover, due to the sintering process, the surface of the porous sintered coating and thereby the open pores of the sintered coating are stable over multiple usages in the MOCVD reaction process. In particular, the porous sintered coating does not change the surface structure significantly over multiple heating and cooling cycles between room temperature and a temperature up to about 2200° Celsius. Thereby, not only the surface structure, but also the emissivity value is kept substantially stable over multiple usages. This object is achieved by only one single coating which is at least partly used to cover the heating body. The production of such single coating is a lot easier and less expensive than the production of more in particular two coatings of the full heating body.

The sintered material, which is used to produce the porous sintered coating, is for example and in particular pure tungsten. The particle size of the sintered material can for example be of the size between about 0.5 and 10 µm. For the porous sintered coating, as used herein, the term "pure tungsten", means a tungsten containing material comprising at least 90% by weight of tungsten. One useful material for the porous sintered coating and/or the heating body is a vacuum metalized tungsten material (VMW). VMW material is tungsten doped with ppm levels of aluminum potassium silicate. The combination of doping and deformation develops a grain structure, which results in increased recrystallization temperature and improved high-temperature sag-resistance. Because of its doping and grain structure VMW shows better ductility than pure tungsten.

An inventive heating element can also comprise connection parts, so-called terminals, for mechanical support and/or electrification of the heating element. Such connection parts are also in particular made of a material that comprises at least 90% by weight of tungsten. The thickness of the porous sintered coating is in particular between 1 and 1000 µm. It is preferred to reduce the thickness of the material of the porous sintered coating to a value between 3 and 200 µm. Due to this reduction, a coating can be achieved which is relatively easy and inexpensive to manufacture and supplies a surface structure for the increase of emissivity of the heating element according to the present invention. One example of a useful heating element 100 is found in "TERMINAL FOR MECHANICAL SUPPORT OF A HEATING ELEMENT", US application No. 13/568,928 filed on August 7, 2012, the contents of which are hereby incorporated herein by reference.

The pores of the porous sintered coating are relatively big. In particular, a porous sintered coating has to be distinguished from a sintered coating without any pores, namely, a compacted sintered coating or a fully sintered coating.

It is possible according to the present invention, that the inventive heating element is characterized in that the heating body is substantially of a flat dimension. The heating body of a substantially flat dimension leads to a heating element of substantially flat dimensions. Since the porous sintered coating comprises a thickness, which is almost or substantially of an equal thickness all over its geometrical extension, the heating element itself is also substantially of flat dimensions. This is of advantage since a planar heater for a MOCVD reactor is assembled by at least one or more heating elements according to the present invention. Heating bodies of substantially flat dimensions are very easily to be assembled to such a planar heater for a MOCVD reactor. Moreover, such a planar heater and thereby the inventive heating elements for a planar heater need less space below a rotating plate, for example a susceptor, for the targets, namely for example the wafers for the production of LEDs. Also it is relatively easy to manufacture such a heating body of substantially flat dimensions, due to the fact that it can be cut from a plate or a plate like element. Thereby, the heating body of substantially flat dimensions can also be called a heating body which has plate like dimensions. Such a heating body extends substantially within a single plane.

It can also be of advantage that an inventive heating element is characterized in that the porous sintered coating is at least partly metallurgically bonded to the heating body. This leads to the advantage that no further connection layer is necessary. In particular no adhesive material has to be used to bond the porous sintered coating to the heating body. This leads to an easy and less complex construction of the heating element, which makes the manufacturing thereof easy and inexpensive. No further step and no further layer are necessary according to this embodiment of the present invention.

It is also possible according to the present invention that a heating element is characterized in that the heating body further comprises two opposite side faces which are both covered at least partly with the porous sintered coating. This is easier to manufacture due to the fact that both side faces and in particular all faces of the heating body are covered by the porous sintered coating. Any way of excluding some surfaces of the heating body is not necessary and thereby the manufacturing process is simplified. Moreover, the heating of both sides of the heating element is equalized such that the direct heating as well as the indirect heating from the opposite side of the heating element facing away from a rotating plate or a target within a MOCVD reactor can be equalized.

It is also possible that according to the present invention, the inventive heating element is characterized in that the porous sintered coating comprises open pores on the outer surface, wherein the open pores have a projection area that extends over more than 10%, preferably more than 15%, more preferably more than 18%, the surface area of the heating body covered by the porous sintered coating. Preferably, the value is over 20%, more preferably over 30%. However, to keep the stability and durability of the porous sintered coating, the value is preferably below 70%, more preferably below 60%. In other words, the porous sintered coating is the result of a sintered process without complete sintering. In particular no compacted sintering takes place. Stated another way, the sintering process leads to an open sintering result, namely to the porous surface of the porous sintered coating. The porosity of the sintered coating is in particular over 10%. Since open pores on the surface of the porous sintered coating are usually bowl-shaped, they increase the surface relative to the two-dimensional projection area of the two-dimensional surface of the heating body. That way, in particular a full sintering, for example at 1800° Celsius, is substantially avoided.

It is also possible that, according to the present invention, the inventive heating element is characterized in that the porous sintered coating is made of technical pure tungsten. The technical pure tungsten is tungsten with no actively added further alloy material. The use of technical pure tungsten leads to the advantage that less terminal stress between coating and heating body will occur. In particular, the material of the porous sintered coating and the heating body is equal so that during heating up the thermal expansion of the porous sintered coating and the heating body itself are equal to each other.

It is also possible according to the present invention, if an inventive heating element is characterized in that the heating body is at least partly curved within a single flat plane. The heating element can also be curved that way. Due to the curves, in particular circular dimensions can be achieved for the heating element. Planar heaters which have to be circular for example for a rotating circular plate which is adapted to receive the targets, respectively for example the wafers for the LED production, are of advantage. Such circular heaters can be assembled by several heating elements with a curved structure, such that each heating element comprises a part of the circular geometry of the heater. The curvature is at least substantially only one curvature. That has to be understood that any other curvatures in other directions are less important, in particular with a radius greater than 1000 mm. In other words, the heating body is at least partly curved within a single flat plane in a technical meaning.

It is also possible that according to the present invention the inventive heating element is characterized in that the emissivity of the porous sintered coating is greater than or equal to 0.5. In particular higher values for the emissivity, namely for example 0.65 up to 0.75 can be achieved. The increase of the emissivity of the porous sintered coating leads to the fact that the emissivity of the whole heating element has been increased. Thereby, the necessary power for a heating up step is decreased that way.

A further object of the present invention is the use of at least one heating element with the features according to the present invention for a planar heater of a MOCVD reactor. Thereby, the use of such an inventive heating element leads to the same advantages, which have been discussed in detail above with respect to the inventive heating element.

A further object of the present invention is to provide a reactor comprising a chamber, a susceptor onto which one or more wafers are mounted and the heating element according to the present invention. Thereby, the use of such an inventive heating element leads to the same advantages, which have been discussed in detail above with respect to the inventive heating element.

A further object of the present invention is a method for manufacturing a heating element, in particular for a planar heater of a MOCVD reactor, comprising the following steps:
- Providing a heating body extending substantially within a single plane and which is made of a material comprising at least 90% by weight of tungsten,
- Applying at least partly on a surface of the heating body a suspension comprising particles of a material which is at least 90% by weight of tungsten, and
- Sintering the suspension on the heating body surface to a porous sintered coating.

The suspension itself further comprises, for example, solvent and binding components. The solvent and binding component can be evaporated before or during the sintering step. Drying of the applicated suspension can take place during sintering and/or during a separate step. Of course a further step, for example a cutting step, can be used to define the exact and preferred curvature of the heating element. Such a cutting step can for example be carried out by water jet or laser cutting. The application of the suspension can be carried out in particular by spraying the suspension. This leads to an optimized thickness of the applicated suspension coating and thereby leading to an equalized thickness of the sintered coating. Such a method leads in particular to a heating element according to the present invention and thereby the same advantages are achieved which have already been discussed in detail with respect to the inventive heating element.

The inventive method can be characterized in that the step of sintering is carried out at a temperature below the full sinter temperature of tungsten. In particular the sintering temperature is below 1800° Celsius. The sintering step can for example be carried out at a temperature between 1400° Celsius and 1500° Celsius. By carrying out the sintering step at a lower temperature, the porosity of the porous sintered coating can be optimized and the emissivity can be increased.

It is also possible that according to the present invention, the sintering step of the method is carried out under exclusion of air oxygen. Of course, also alternative atmosphere, namely hydrogen atmosphere or argon atmosphere is possible. The exclusion of air oxygen leads to a more clean sintering step due to the fact that oxidation reactions are excluded from the sintering process.

It is also possible according to the present invention that the method is carried out to manufacture a heating element according to the present invention.

It is also an object of the present invention to provide a heating body according to the inventive method having an emissivity greater than or equal to 0.5.

The present invention is discussed in more detail, with respect to the accompanying drawings. The drawings show schematically:
- Figure 1: A first embodiment of an inventive heating element,
- Figure 2: A further embodiment of an inventive heating element,
- Figure 3: A further embodiment of an inventive heating element,
- Figure 4: A further embodiment of an inventive heating element,
- Figure 5a: One embodiment of an inventive heating element in a cross-sectional view,
- Figure 5b: The embodiment of Figure 5a in a higher resolution,
- Figure 5c: The embodiments of Figure 5a and 5b in a top view,
- Figure 6a: A plate during a 1^{st} step of an inventive method,
- Figure 6b: The schematic view of a 2^{nd} step of the inventive method,
- Figure 6c: A schematic view of the 3^{rd} step of an inventive method,
- Figure 6d: A schematic view of the 4^{th} step of the inventive method.

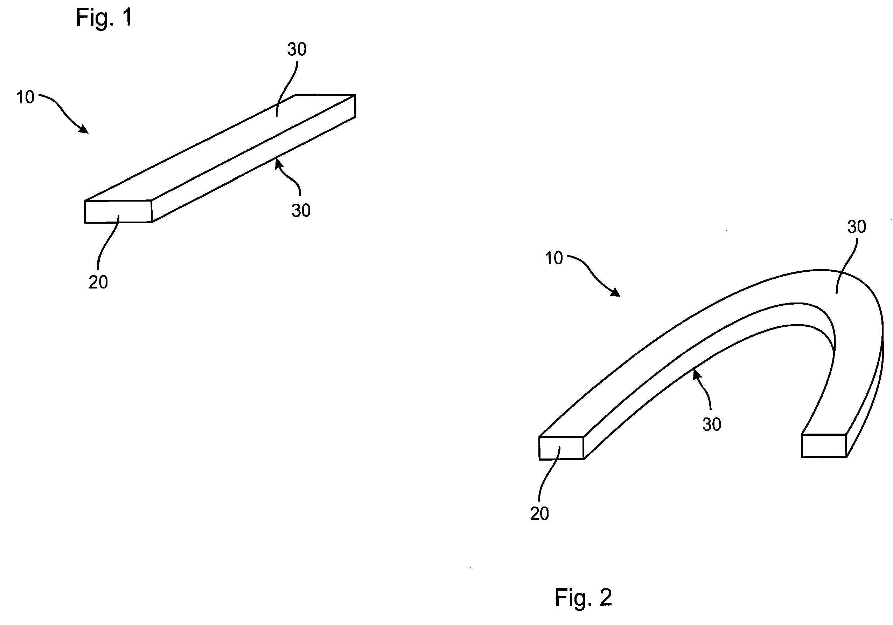

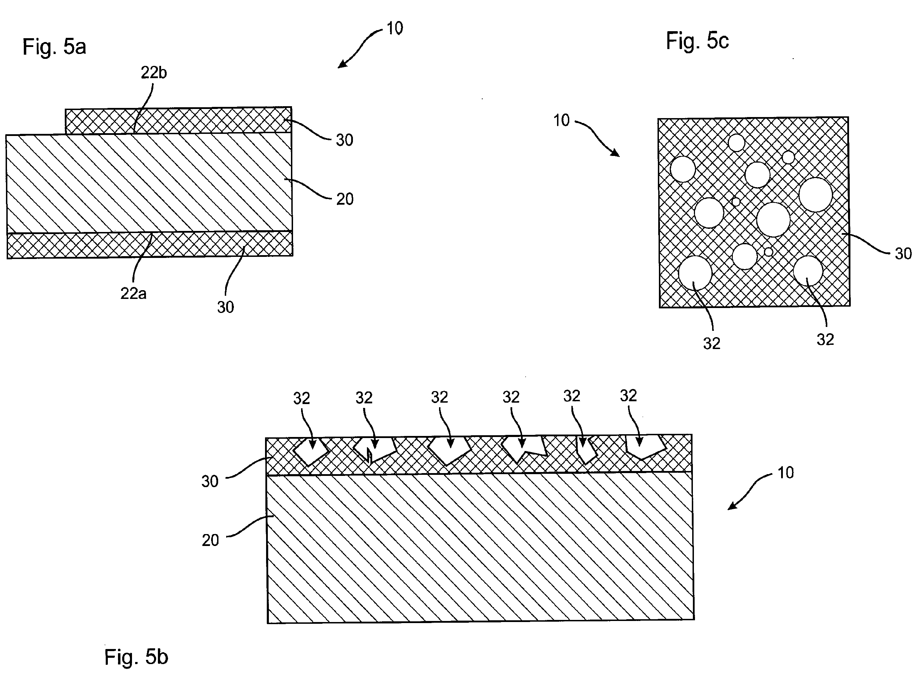

In Figures 1, 2, 3 and 4 different geometrical ways to carry out an inventive heating element 10 are shown. For example in Figure 1, a heating element 10 is disclosed which comprises a heating body 20 of substantially straight extension. The heating body 20 is substantially plate like, or of substantially flat dimensions. That means that the thickness is relatively to the length and the wide of the heating body 20 relatively small. The heating body 20 of Figure 1 is covered on the upper and lower side with a porous sintered coating 30. Details with respect to that porous sintered coating will be explained later with respect to Figures 5a, 5b and 5c.

Figure 2 shows a further embodiment of an inventive heating element 10. It is also of plate-like or substantially flat dimensions. However this embodiment of the heating element 10 comprises a heating body 20 which is curved in substantially one single plane. Also this heating body 20 has been covered on both sides, namely the upper and the lower side, with a porous sintered coating 30.

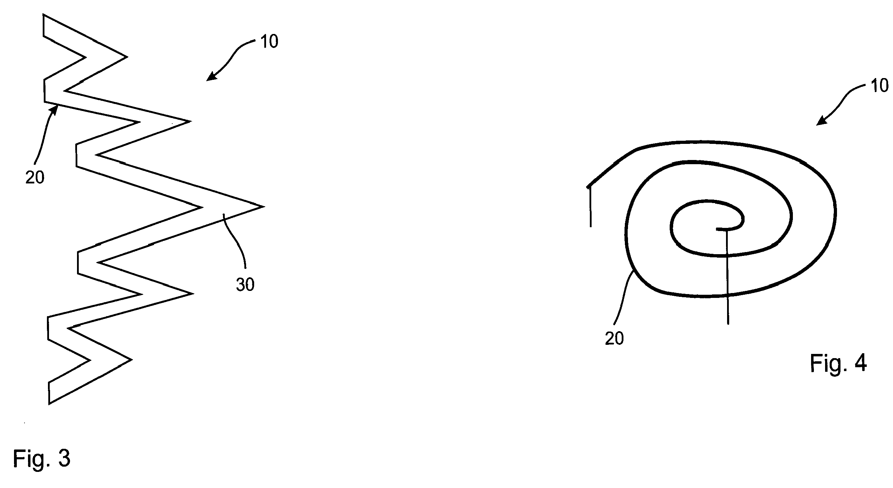

Figure 3 discloses a possibility of a heating element 10 with a complex structure. For example that heating element 10 with plate like dimensions comprises several straight areas of the heating body 20, combining itself together to a complex structure. If such a complex structure made of several substantially straight lines is combined with further heating elements 10 of same or similar structure, more complex structures of a planar heater, for example in particular circular structures of the heater can be achieved.

It is also possible, if the heating element 10 comprises a curved structure which is of almost circular extension. Such an embodiment is shown for example in Figure 4. In Figure 3 and Figure 4 both heating bodies 20 are covered at least partly with a porous sintered coating 30. The coverage of the porous sintered coating is in particular focused on the area of the heating body 20, which faces a target during the use in a MOCVD reactor.

Figures 5a, 5b and 5c show one example of the porous sintered coating 30. As it can be seen in Figure 5a, the heating body 20 of the heating element 10 is covered on its upper side and its lower side with a porous sintered coating 30. The two side faces 22a and 22b are covered with that porous sintered coating 30 in particular by metallurgical bonding of the porous sintered coating 30 with the material of the heating body 20. Both, the heating body 20 and the porous sintered coating 30 are made of a material comprising at least 90% by weight of tungsten. In particular the material of the heating body 20 and the material of the porous sintered coating 30 are identical to each other. In Figure 5a the upper porous sintered coating 30 covers the heating body 20 only partly.

Figure 5b shows a higher resolution of the porous sintered coating 30. As it can be seen here, the porous sintered coating 30 comprises at least several open pores 32. An open pore 32 is a pore of the porous sintered coating 30, which is open on the surface of the porous sintered coating 30. The open pores 32 lead to an increase of the whole surfaces structure of the porous sintered coating 30 relative to the projection surface area from a top view in Figure 5b. As it can be seen in Figure 5c, the pores are randomly placed in the porous sintered coating 30.

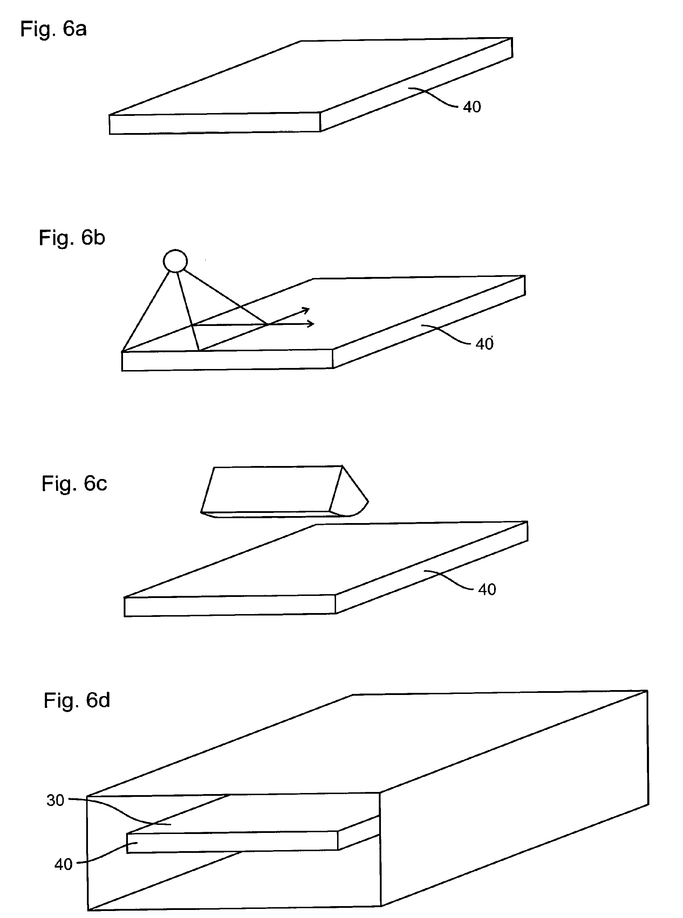

Figures 6a to 6d show one possibility to carry out an inventive method. In a first step, a plate 40 is provided. Later on for example after the sintering step, the plate 40 is cut during a cutting step, for example a water jet or laser cutting step, to achieve the explicit geometrical dimensions of one or more heating elements 10. Of course it is also possible to cut the plate before applying the porous sintered coating 30 to achieve one or more heating bodies 20.

Figure 6b shows a second step, namely the application of the suspension comprising a part of a material with over 90% by weight of tungsten directly on at least one side of the plate. After in particular spraying the suspension on at least one side of the plate 40, it is dried in a third step, for example with infrared light, as it can be seen in Figure 6c.

As a for example final step of an inventive method, a sintering step takes place in a sinter chamber. Schematically this is shown in Figure 6d. During that sinter step, the applied suspension is sintered at a temperature for example below 1800° Celsius, in particular with a temperature between 1400 and 1500° Celsius. After that sintering step, the suspension has been sintered to a porous sintered coating and thereby the plate 40 can be used directly or after a cutting step as a heating element 10 with a porous sintered coating 30.

### REFERENCE SIGNS

- 10: heating element
- 20: heating body
- 22a: side face
- 22b: side face
- 30: porous sintered coating
- 32: open pores
- 40: plate

## Claims

1. Method for manufacturing a heating element (10), comprising the following steps:
• Providing a heating body (20) extending substantially within a single plane and which is made of a material comprising at least 90 % by weight of tungsten;
• Applying at least partly on a surface of the heating body a suspension comprising particles of a material which is at least 90 % by weight of tungsten; and
• Sintering the suspension on the heating body surface to a porous sintered coating (30).

2. Method according to claim 1, **characterized in that** the suspension is dried before the sintering step.

3. Method according to claim 1, **characterized in that** the suspension is dried during the sintering step.

4. Method according to any of claims 1 to 3, **characterized in that** the step of sintering is carried out at a temperature below the full sinter temperature of tungsten.

5. Method according to claim 4, **characterized in that** the sintering step is carried out at a temperature below 1800° Celsius.

6. Method according to any of claims 1 to 5, **characterized in that** the sintering step is carried out at a temperature between 1400°C and 1500°C.

7. Method according to any of claims 1 to 6, **characterized in that** the sintering step is carried out under exclusion of air oxygen.

8. Method according to any of claims 1 to 7, **characterized in that** the sintering step is carried out in a hydrogen atmosphere or an argon atmosphere.

9. Heating body (10) made according to the method of any of claims 1 to 8 having an emissivity greater than or equal to 0.5.
